# EUROPÄISCHE PATENTANMELDUNG

(11) **EP 4 195 886 A2**
(43) Veröffentlichungstag der Anmeldung: **14.06.2023**
(21) Anmeldenummer: 22209930.1
(22) Anmeldetag: 28.11.2022
(51) Int. Cl.: H05K 3/34, H05K 3/22, H01L 23/00

(54) **VERFAHREN ZUM ERSETZEN EINES AUF EINER LEITERPLATTE AUFGEBRACHTEN BAUTEILS**

(30) Priorität: 01.12.2021 DE 102021131687
(71) Anmelder: Endress+Hauser SE+Co. KG, 79689 Maulburg (DE); Fraunhofer-Gesellschaft zur Förderung der angewandten Forschung e.V., 80686 München (DE)
(72) Erfinder: Hippin, Christoph, 79639 Grenzach (DE); Schimanski, Helge, 25524 Itzehoe (DE)
(74) Vertreter: Trenkle, Dennis

(57) **Zusammenfassung**

Die Erfindung betrifft ein Verfahren zum Ersetzen eines auf einer Leiterplatte (2) aufgebrachten ersten Bauteils (1) durch ein baugleiches zweites Bauteil (1'), umfassend:
- Entfernen des ersten Bauteils (1) von der Leiterplatte (2), so dass jeweils eine, insbesondere auf jedem der Kontaktpads (21) identische, Restlotmenge mit einer definierten Dicke (d) auf den Kontaktpads (21) bestehen bleibt;
- Vorbereiten des zweiten Bauteils (1') mittels der Fräsmaschine:
i. Positionieren und Fixieren des zweiten Bauteils (1') auf dem Maschinentisch, wobei das zweite Bauteil (1') derart auf dem Maschinentisch positioniert wird, dass die Oberfläche mit der Vielzahl von Anschlüssen von dem Maschinentisch abgewandt ist;
ii. Versetzen des Fräswerkzeugs (3) in Rotationsbewegung und Bewegen des Fräswerkzeugs (3) auf eine vorgegebene erste Höhe (h1) von der Oberfläche des zweiten Bauteils (1') entfernt, welche vorgegebene erste Höhe (h1) um die definierte Dicke (d) der Restlotmenge der Kontaktpads (21) der Leiterplatte (2) kleiner als der Durchmesser der Lotkugeln (12') ist;
iii. Reduzieren des Lotvolumens von jeder der Lotkugeln (12') mittels des Fräswerkzeugs (3);

- Anlöten des zweiten Bauteils (1') auf die Leiterplatte (2) durch ein Reflow-Lötverfahren.

## Beschreibung

Die Erfindung betrifft ein Verfahren zum Ersetzen eines auf einer Leiterplatte aufgebrachten ersten Bauteils durch ein baugleiches zweites Bauteil, wobei das erste Bauteil ein Gehäuse und eine Oberfläche mit einer Vielzahl von Anschlüssen aufweist, wobei jeder der Anschlüsse über eine separate Lötverbindung mit jeweils einem Kontaktpad der Leiterplatte verbunden ist, wobei das zweite Bauteil jeweils ein Gehäuse und eine Oberfläche mit einer Vielzahl von Anschlüssen mit jeweils einer Lotkugel mit einem vorgegebenen Durchmesser aufweist, wobei die Fräse einen planaren Maschinentisch und ein Fräswerkzeug aufweist.

Aus der Leiterplattenfertigung sind verschiedene Verfahren zur Bestückung der Leiterplatten bekannt. Unter Leiterplatten werden bspw. PCBs verstanden, aber auch Substrate, auf welchen elektronische Bauteile aufgebracht werden, beispielsweise FR4, allgemeine Hochfrequenzmaterialien (unter anderem Rogersmaterialien), Keramiken, DCB (Direct Copper Bonding), etc.

Beispielsweise werden so genannten SMD-Bauteile (Surface Mounted Device) auf Kontaktflächen auf der Vorderseite der Leiterplatte montiert. THT-Bauteile (Through-Hole-Technology) hingegen besitzen Anschlussdrähte, welche durch eine Öffnung in der Leiterplatte gesteckt und auf der gegenüberliegenden Seite der Leiterplatte befestigt werden. Hierbei ist auch eine Mischbestückung mit SMD- und THT-Bauteilen möglich. Das Löten von SMD-Bauteilen erfolgt in der Regel in einem Reflow-Lötverfahren. Zur Vorbereitung hierzu wird die Leiterplatte an den zu bestückenden Stellen mit Lotpaste versehen, welche ein Lotpastendepot bildet. Anschließend wird das Bauteil auf dem entsprechenden Lotpastendepot positioniert. Die so bestückte Leiterplatte wird einer Wärmequelle ausgesetzt, beispielsweise auf eine Heizplatte aufgelegt oder einem Lötofen zugeführt, wobei die Lotpaste aufgeschmolzen und hierdurch eine Verbindung des Bauteils mit der Leiterplatte hergestellt wird.

Es kann vorkommen, dass Bauteile fehlerhaft sind oder im Laufe des Betriebes ausfallen. Insbesondere bei kostenintensiven Bauteilen oder bei Baugruppen mit einer Vielzahl an Bauteilen wird in einem solchen Fall nicht die komplette Baugruppe entsorgt, sondern das fehlerhafte oder defekte Bauteil ausgetauscht. Bisher werden defekte Bauteile auf bestückten Leiterplatten durch einen thermischen Prozess ausgelötet. Das Ersetzen, bzw. Wiedereinlöten erfolgt ebenfalls mittels eines thermischen Prozesses.

Von der Firma "ZEVAC" werden Maschinen vertrieben, welche ein Entfernen von Bauteilen mittels eines "Milling" genannten Verfahrens ermöglichen. Das Verfahren bietet die Möglichkeit, elektronische Bauteile mittels eines Fräsvorgangs von der Leiterplatte zu entfernen, wodurch ein thermischer Prozess vermieden wird. Der Fräskopf wird hierbei auf Höhe des Bauteils abgesenkt und anschließend eine Bewegung des Fräskopfes in x-y-Richtung durchgeführt, bis das gesamte Bauteil abgefräst ist. Die Leiterplatte wird dadurch weniger thermischem Stress ausgesetzt, wodurch einer künstlichen Alterung vorgebeugt wird.

In der Patentanmeldung mit dem Aktenzeichen DE102019118573.4 ist ein alternatives Verfahren zum Entfernen von Bauteilen mittels eines Fräsvorgangs beschrieben. Hierbei werden nacheinander die einzelnen Lötverbindungen durch eine z-Bewegung des Fräskopfes entfernt. Beim Abfräsen bestimmter Bauteile, bspw. Ball Grid Array-Bauteilen, unter den x-y-Vorschubrichtungen werden relativ große Kräfte wirksam, welche zu einer Verschmierung des Lotes sowie zum Abriss von Leiterbahnen oder Pads auf der Leiterplatte führen können. Diese Nachteile treten bei dem Verfahren der genannten Patentanmeldung nicht auf.

Aus Sicht der Aufbau und Verbindungstechnik sollte das Lot zwischen Leiterplatte und dem Bauteil möglichst komplett entfernt werden. Auf Grund von Frästoleranzen und damit das Kontaktpad der Leiterplatte und die Leiterplatte selbst nicht beschädigt werden, verbleibt ein größerer Rest des Lotes aus der Verbindungsstelle auf dem Kontaktpad zu belassen. Die Restlotmenge kann dabei noch eine Lothöhe von 50µm bis zu 100µm aufweisen.

Wird nun ein neues Bauteil auf die Stelle des abgefrästen Bauteils gesetzt, so wird dieses Restlot zum Problem. Wird beispielsweise als Bauteil ein Ball-Grid-Array mit Lotkugeln mit einem Durchmesser vom 300 µm verwendet, so kann die Lotmenge beim Umschmelzvorgang zusammen mit dem vorhandenen Restlot so groß werden, dass Verkippungen und/oder Kurzschlüsse in den Lötverbindungen zwischen Bauteil und Kontaktpad entstehen können.

Mit den oben beschriebenen Fräsmethoden sind die Toleranzen und Anforderungen an die Höhe des Restlotes über dem Pad nicht zu realisieren. Das Restlot könnte zwar mittels Restlotabsaugung entfernt werden. Hierbei ist aber der Nachteil, dass dies ein thermischer Prozess ist, wodurch die Leiterplatte sowie umliegende Bauteile belastet und eventuell zerstört werden könnten. Genau diese thermischen Prozesse und Einwirkungen sollen aber gerade durch Verwenden einer Fräsmethode vermieden werden.

Die Aufgabe der vorliegenden Erfindung besteht daher darin, ein Bauteil einer Leiterplatte derart zu ersetzen, dass fehlerfreie Lötverbindungen zwischen Leiterplatte und dem neuen Bauteil gewährleistet sind.

Die Aufgabe wird durch ein Verfahren zum Ersetzen eines auf einer Leiterplatte aufgebrachten ersten Bauteils durch ein baugleiches zweites Bauteil gelöst, wobei das erste Bauteil ein Gehäuse und eine Oberfläche mit einer Vielzahl von Anschlüssen aufweist, wobei jeder der Anschlüsse über eine separate Lötverbindung mit jeweils einem Kontaktpad der Leiterplatte verbunden ist, wobei das zweite Bauteil jeweils ein Gehäuse und eine Oberfläche mit einer Vielzahl von Anschlüssen mit jeweils einer Lotkugel mit einem vorgegebenen Durchmesser aufweist, wobei die Fräse einen planaren Maschinentisch und ein Fräswerkzeug aufweist, umfassend:
- Entfernen des ersten Bauteils von der Leiterplatte, so dass jeweils eine, insbesondere auf jedem der Kontaktpads identische, Restlotmenge mit einer definierten Dicke auf den Kontaktpads bestehen bleibt;
- Vorbereiten des zweiten Bauteils mittels einer Fräsmaschine, wobei die Fräsmaschine einen planaren Maschinentisch und ein Fräswerkzeug aufweist:
   i. Positionieren und Fixieren des zweiten Bauteils auf dem Maschinentisch, wobei das zweite Bauteil derart auf dem Maschinentisch positioniert wird, dass die Oberfläche mit der Vielzahl von Anschlüssen von dem Maschinentisch abgewandt ist;
   ii. Versetzen des Fräswerkzeugs in Rotationsbewegung und Bewegen des Fräswerkzeugs auf eine vorgegebene erste Höhe von der Oberfläche des zweiten Bauteils entfernt, welche vorgegebene erste Höhe um die definierte Dicke der Restlotmenge der Kontaktpads der Leiterplatte kleiner als der Durchmesser der Lotkugeln ist;
   iii. Reduzieren des Lotvolumens von jeder der Lotkugeln mittels des Fräswerkzeugs;
- Versehen der reduzieren Lotkugeln des zweiten Bauteils mit einem Flussmittel;
- In Kontakt Bringen des zweiten Bauteils mit der Leiterplatte, wobei jeder der Anschlüsse des zweiten Bauteils auf ein korrespondierendes Kontaktpad platziert wird;
- Anlöten des zweiten Kontaktpads an die Leiterplatte durch ein Reflow-Lötverfahren.

Das erfindungsgemäße Verfahren basiert auf drei Verfahrensschritten: Dem Entfernen des alten (ersten) Bauteils, dem Vorbereiten des neuen (zweiten) Bauteil und dem Aufbringen des neuen Bauteils auf der Leiterplatte. Der Schwerpunkt der Erfindung liegt dabei auf der Lotreduzierung an jedem der Anschlüsse des neuen Bauteils durch Abfräsen der vorhandenen Lotkugeln, um die für das Anlöten benötigte Lotmenge "einzustellen". Die Menge des jeweils abzufräsenden Lots wird hierbei durch die Dicke der Restlotmenge auf der Leiterplatte definiert.

Das erfindungsgemäße Verfahren bietet den Vorteil, dass thermische Prozesse bei der Reparatur bzw. dem Austausch von bestückten elektronischen Komponenten einer Leiterplatte eingespart werden können.

Ein Kontaktpad ist eine leitfähige Fläche oder Beschichtung, insbesondere metallisch, auf der Leiterplatte, welche nach Verbindung eines Anschlusses des Bauteils den Anschluss mit einer Komponente der Leiterplatte, beispielsweise eine Leiterbahn, elektrisch verbindet.

Unter dem Begriff Leiterplatten werden neben beispielsweise PCBs auch allgemein Substrate verstanden, auf welchen elektronische Bauteile aufgebracht werden können, beispielsweise FR4, allgemeine Hochfrequenzmaterialien (unter anderem Rogersmaterialien), Keramiken, DCB (Direct Copper Bonding), etc.

Gemäß einer vorteilhaften Ausgestaltung des erfindungsgemäßen Verfahrens ist vorgesehen, dass zum Reduzieren des Lotvolumens der Lotkugeln die vorgegebene erste Höhe des Fräswerkzeugs beibehalten wird und dass das Fräswerkzeug in einer zur Oberfläche des Bauteils im Wesentlichen parallelen Ebene über alle Anschlüsse hinweg, insbesondere mäanderförmig, bewegt wird. Diese Variante entspricht von der prinzipiellen Vorgehensweise her dem bekannten "Milling"-Fräsverfahren, in welchem der Fräskopf in einer x-y-Richtung bewegt wird, welches hier für das Vorbereiten des Bauteils adaptiert wird.

Gemäß einer vorteilhaften Ausgestaltung des erfindungsgemäßen Verfahrens ist vorgesehen, dass zum Reduzieren des Lotvolumens der Lotkugeln das Fräswerkzeug über jede Position eines Anschlusses in einer die Lotkugel nicht berührenden Ausgangshöhe gefahren wird, und dass das Lötwerkzeug für jeden Anschluss bei Erreichen der entsprechenden Position des Anschlusses in einer zur Oberfläche des Bauteils orthogonalen Richtung auf die vorbestimmte erste Höhe und anschließend zurück auf die Ausgangshöhe gefahren wird. Diese Variante entspricht von der prinzipiellen Vorgehensweise her dem in der Patentanmeldung mit dem amtlichen Aktenzeichen DE102019118573.4 beschriebenen z-Achsenfräsen, welches hier für das Vorbereiten des Bauteils adaptiert wird.

Gemäß einer vorteilhaften Ausgestaltung des erfindungsgemäßen Verfahrens ist vorgesehen, dass die Leiterplatte zum Entfernen des ersten Bauteils auf den Maschinentisch der Fräse positioniert wird und dass das erste Bauteil mittels der Fräse entfernt wird.

Gemäß einer ersten Variante des erfindungsgemäßen Verfahrens ist vorgesehen, dass zum Entfernen des ersten Bauteils die folgenden Verfahrensschritte durchgeführt werden:
- Positionieren des Fräswerkzeugs über der Position eines ersten Anschlusses, wobei sich das Fräswerkzeug in einer die Leiterplatte nicht berührenden Ausgangshöhe über der Leiterplatte befindet;
- Versetzen des Fräswerkzeugs in Rotationsbewegung und Bewegen des Fräswerkzeugs durch das Bauteil hindurch in einer zu der Oberfläche der Leiterplatte im Wesentlichen orthogonalen Richtung auf eine vorgegebene zweite Höhe über der Leiterplatte;
- Zurückbewegen des Fräswerkzeugs auf die Ausgangshöhe;
- Wiederholen der Verfahrensschritte a) bis c) für die weiteren Anschlüsse.

Dieses Verfahren wird in der Patentanmeldung mit dem amtlichen Aktenzeichen DE102019118573.4 ausführlich beschrieben.

Es ist vorgesehen, dass das Bauteil mittels eines Hilfsmittels, beispielsweise einer Klemme, an der Leiterplatte fixiert wird. Das verhindert ein unerwünschtes Bewegen oder Abreißen des Bauteils während des Abfräsens im fortschreitenden Verlauf, wenn nur noch wenige abzufräsende Anschlüsse vorhanden sind.

Gemäß einer zweiten Variante des erfindungsgemäßen Verfahrens ist vorgesehen, dass zum Entfernen des ersten Bauteils das Fräswerkzeug auf eine vorgegebene zweite Höhe gefahren wird und wobei das Fräswerkzeug unter Beibehalten der zweiten Höhe in einer zur Oberfläche des Bauteils im Wesentlichen parallelen Ebene über alle Anschlüsse hinweg, insbesondere mäanderförmig, bewegt wird. Dieses Verfahren entspricht dem bekannten "Milling"-Fräsverfahren, in welchem der Fräskopf in einer x-y-Richtung bewegt wird.

Gemäß einer vorteilhaften Ausgestaltung des erfindungsgemäßen Verfahrens ist vorgesehen, dass die zweite Höhe derart gewählt wird, dass die definierte Dicke der Restlotmenge in einem Bereich zwischen 10 µm bis 90 µm liegt. Bevorzugter Weise weist die Restlotmenge eine definierte Dicke zwischen 15 µm bis 50 µm. Besonders bevorzugter Weise weist die Restlotmenge eine definierte Dicke zwischen 15 µm bis 30 µm. Diese spezifische Dicke ermöglicht ein einfaches Anbringen eines neuen Bauteils.

Gemäß einer vorteilhaften Ausgestaltung des erfindungsgemäßen Verfahrens ist vorgesehen, dass die Leiterplatte nach Entfernen des ersten Bauteils mittels einer Höhenvermessung, insbesondere eine Laserhöhenvermessung, vermessen wird und eine Abweichung der tatsächlichen Dicke der Restlotmenge von der definierten Dicke der Restlotmenge für jedes der Kontaktpads bestimmt wird. Im idealen Fall weisen die Restlotmengen der einzelnen Anschlüsse dieselbe Dicke nach dem Durchführen des Fräsvorgangs auf. In Einzelfällen, beispielsweise wenn das Bauteil eine leichte Biegung aufweist oder nicht eben auf dem Maschinentisch liegt, können sich die resultierenden Dicken unterscheiden.

Gemäß einer vorteilhaften Ausgestaltung des erfindungsgemäßen Verfahrens ist vorgesehen, dass vor dem Reduzieren des Lotvolumens der Lotkugeln die vorgegebene erste Höhe für jeden Anschluss mittels des Ergebnisses der Höhenvermessung korrigiert wird, so dass das Fräswerkzeug für jeden Anschluss die korrigierte erste Höhe verwendet. Somit ist gewährleistet, dass die Restlotmengen der einzelnen Anschlüsse dieselbe Dicke nach dem Durchführen des Fräsvorgangs aufweisen.

Gemäß einer vorteilhaften Ausgestaltung des erfindungsgemäßen Verfahrens ist vorgesehen, dass das Fräswerkzeug zum Entfernen des ersten Bauteils und/oder Reduzieren des Lotvolumens der Lotkugeln des zweiten Bauteils in eine Rotationsbewegung mit einer Geschwindigkeit zwischen 10.000 rpm (Umdrehungen pro Minute) und 90.000 rpm, bevorzugt zwischen 60.000 rpm und 90.000 rpm, versetzt wird.

Gemäß einer vorteilhaften Ausgestaltung des erfindungsgemäßen Verfahrens ist vorgesehen, dass als erstes Bauteil und als zweites Bauteil auf der Ball Grid Array-, Pin Grid Array- oder Land Grid Array-Technologie basierende Bauteile verwendet werden. Es können beliebige weitere SMD-Bauteiltypen verwendet werden, welche eine Vielzahl von Anschlüssen mit Lotkugeln aufweisen und mittels Lötverbindungen mit der Leiterplatte verbindbar sind.

Des Weiteren wird die Aufgabe durch ein Fräswerkzeug gelöst, welches zur Verwendung in dem erfindungsgemäßen Verfahren ausgestaltet ist.

Gemäß einer vorteilhaften Ausgestaltung des erfindungsgemäßen Fräswerkzeugs ist vorgesehen, dass der Durchmesser des Fräswerkzeugs größer gleich dem Durchmesser der Lotkugeln ist. Insbesondere wird hierbei der größte verfügbare Durchmesser der auf der Leiterplatte vorhandenen Lotanschlüsse gewählt.

Gemäß einer vorteilhaften Ausgestaltung des erfindungsgemäßen Fräswerkzeugs ist vorgesehen, dass der Durchmesser des Fräswerkzeugs kleiner als die Summe des Durchmessers der Lotkugeln und dem zweifachen kleinsten Abstand zwischen zwei Lotkugeln ist. Hierdurch wird bewirkt, dass bei einer Fräsbewegung in z-Achse (gemäß Anspruch 4) nur auf eine einzelne Lötverbindung gefräst wird.

Die Erfindung wird anhand der nachfolgenden Figuren näher erläutert. Es zeigen
Fig. 1: eine schematische Darstellung eines Querschnitts durch ein auf einer Leiterplatte aufgebrachtes Bauteil;
Fig. 2: eine schematische Darstellung der Unterseite des Bauteils;
Fig. 3: eine schematische Darstellung eines Fräsverfahren zum Entfernen eines ersten Bauteils von einer Leiterplatte;
Fig. 4: eine schematische Darstellung eines alternativen Fräsverfahren zum Entfernen des ersten Bauteils von einer Leiterplatte; und
Fig. 5: eine schematische Darstellung eines Fräsverfahrens zum Vorbereiten eines zweiten Bauteils.

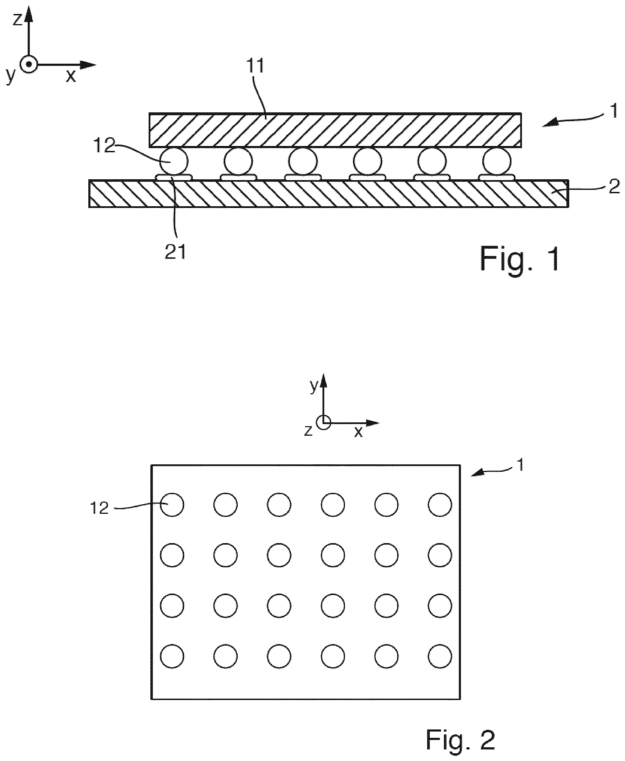

In Fig. 1 ist ein erstes Bauteil 1 gezeigt, welches auf einer Leiterplatte 2 aufgebracht ist. Die Oberfläche der Leiterplatte 2 definiert eine Ebene in x- und y-Richtung. Orthogonal zu dieser Ebene liegt eine z-Richtung. Dieses definierte Koordinatensystem wird im Zusammenhang mit der gesamten Erfindung verwendet.

Die Leiterplatte umfasst eine Vielzahl von Kontaktpads 21, beispielsweise aus Kupfer, welche mit Leiterbahnen verbunden sind. Als erstes Bauteil 1 wird in diesem Beispiel ein Ball-Grid-Array-Bauteil verwendet. Dieses weist eine Vielzahl von Anschlüssen auf, welche an einer Unterseite des Gehäuses des ersten Bauteils 1 angebracht sind und welche beispielsweise in einem zweidimensionalen Raster angeordnet sind. Das Gehäuse umschließt die Elektronik des ersten Bauteils. Jedem Anschluss ist eine Lotkugel 12 zugeordnet. Diese Lotkugeln 12 werden zum Beispiel beim Reflow-Konvektionslöten, Reflow-IR-Löten und/oder Dampfphasen- Löten in einem Lötofen aufgeschmolzen und verbinden sich mit den Kontaktpads 21 auf der Leiterplatte 2, wodurch die Lötverbindungen gebildet werden. Ein Beispiel für ein solches Raster ist in Fig. 2 gezeigt, in welcher die Unterseite des Bauteils 1, 1' abgebildet ist.

Nach Aufbringen des ersten Bauteils 1 auf der Leiterbahn 2 wird dieses getestet, insbesondere elektronisch getestet und/oder optisch oder mittels Röntgens analysiert. Stellt sich heraus, dass das erste Bauteil 1 nicht funktionsgemäß arbeitet, beispielsweise durch eine Beschädigung des ersten Bauteils 1 oder durch eine fehlerhafte Lötverbindung, so ist oftmals die gesamte Leiterplatte 1 unbrauchbar. Da eine Leiterplatte 1 oftmals eine Vielzahl solcher Bauteile 1 aufweist, ist ein Entsorgen der gesamten Leiterplatte 1, insbesondere aus Kostengründen, keine Option. Es ist daher wünschenswert, das defekte erste Bauteil 1 zu entfernen, und zwar derart, dass auf selber Stelle auf der Leiterplatte 1 ein neues, funktionsfähiges zweites Bauteil 1' aufgebracht werden kann.

Zum Entfernen des ersten Bauteiles wird erfindungsgemäß ein Fräsverfahren unter Verwendung eines Fräswerkzeugs 3 verwendet.

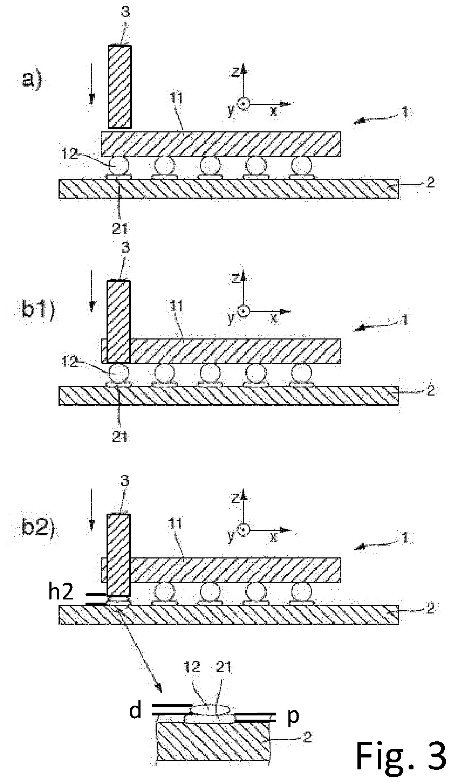

In Fig. 3 ist eine erste Variante zum Entfernen des ersten Bauteils 1 gezeigt. Diese Variante entspricht dem in der Patentanmeldung mit dem amtlichen Aktenzeichen DE102019118573.4 beschriebenen z-Achsenfräsen. In einem ersten Verfahrensschritt a) wird die Leiterplatte 2 mit dem bestückten ersten Bauteil 1 auf einem Maschinentisch einer Fräse, beispielsweise einer CNC-Fräse eingelegt. Anschließend wird das erste Bauteil 1 analysiert, insbesondere optisch, um das Höhenprofil des Bauteils 1 auf der Leiterplatte 2 zu detektieren. Dies dient dem Zweck, eine eventuelle Höhenverschiebung des Bauteils ersten 1 gegenüber der idealen Lage des ersten Bauteils 1 auf der Leiterplatte (idealerweise sollte das Bauteil parallel zur Oberfläche der Leiterplatte angebracht sein) festzustellen.

Anschließend wird eine vorbestimmte zweite Höhe h2 über der Leiterplatte 2 in z-Richtung bestimmt, also eine Tiefe in z-Richtung von der Ausgangsposition des Fräswerkzeugs aus, in welche sich das Fräswerkzeug 3 bewegen soll. Diese zweite Höhe h2 wird derart gewählt, dass eine vorbestimmte Dicke d einer Restlotmenge nach dem Fräsen bestehen bleibt. Berechnet werden kann diese Höhe, indem der Abstand zwischen der oberen Seite des Gehäuses über der Leiterplatte gemessen wird und davon die bekannte Dicke des Gehäuses und der Abstand zwischen der Gehäuseunterseite und der Oberkante der Restlotmenge abgezogen wird. Anschließend wird das vorher bestimmte Höhenprofil herangezogen und die berechnete zweite Höhe h2 entsprechend angepasst, um die Höhenverschiebung zu kompensieren. Dies wird für alle Lötverbindungen einzeln durchgeführt.

Anschließend steuert das Fräswerkzeug 3 die erste Lötverbindung auf der x-y-Ebene an. Dabei befindet sich das Fräswerkzeug in einer Ausgangsposition, in welcher das Fräswerkzeug 3 sich derart abgesetzt von der Leiterplatte 2 in z-Richtung befindet, dass das Fräswerkzeug 3 weder die Leiterplatte 2 noch das Bauteil 1 berührt. Die Lage der Lötverbindungen 12 auf der x-y-Ebene ist in der Software der Fräsvorrichtung programmierbar.

Das Fräswerkzeug 3 wird in einem zweiten Verfahrensschritt b) in Rotationsbewegung versetzt. Anschließend wird das Fräswerkzeug 3 in z-Richtung in Richtung Leiterplatte 2 abgesenkt. Dabei fräst sich das Fräswerkzeug 3 zuerst durch das Gehäuse 11 des ersten Bauteils 1 (siehe Fig. 3 b1)). Das Fräswerkzeug 3 wird weiter abgesenkt und fräst sich durch die Lötverbindung 12, bis es an der vorbestimmten Höhe angelangt (siehe Fig. 3 b2)).

Anschließend wird das Fräswerkzeug 3 in einem Verfahrensschritt c) wieder angehoben und auf die Ausgangsposition zurückgeführt. Die Lötverbindung zwischen dem Bauteil 1 und der Leiterplatte 2 existiert nun nicht mehr. Es ist nur noch die gewünschte Menge an Restlot auf dem Kontaktpad 21 vorhanden.

Im abschließenden Verfahrensschritt d) werden die vorher beschriebenen Verfahrensschritte a) bis c) für jeder der noch existierenden Lötverbindungen wiederholt, wobei das Bauteil durch Verklemmen oder Fixierung beispielsweise mittels eines Hilfsmittels wie einer Klemme gegen Verdrehung gesichert werden muss. Anschließend ist das erste Bauteil 1 abhebbar. Auf die nun verbleibenden Kontaktpads 21 mit den jeweiligen Restlotmengen ist nun ein neues zweites Bauteil 1' aufbringbar.

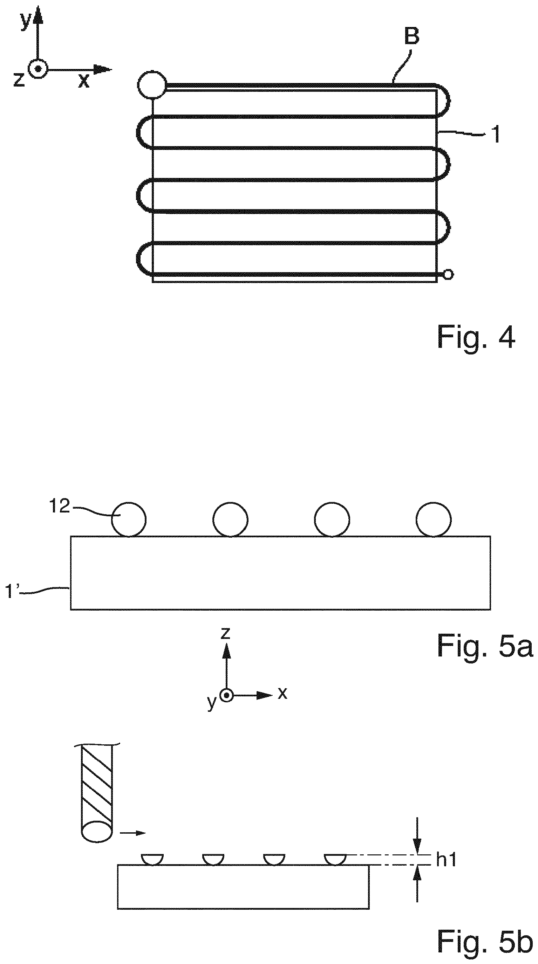

Fig. 4 zeigt ein alternatives Fräsverfahren zum Entfernen des ersten Bauteils 1. Zuerst wird das Fräswerkzeug auf die zweite Höhe h2 gefahren. Anschließend wird das Bauteil in einer x-y-Bewegung B unter Beibehalten der zweiten Höhe h2, insbesondere mäanderförmig, abgetragen. Dieses Verfahren entspricht dem aus dem Stand der Technik bekannten "Milling"-Fräsverfahren.

Fig. 5 zeigt schematisch, wie anschließend das zweite Bauteil 1' vorbereitet wird. Wie in Fig. 5a) gezeigt, wird das zweite Bauteil 1' auf den Maschinentisch aufgelegt, positioniert und fixiert. Hierbei ist die Oberfläche mit der Vielzahl von Anschlüssen mit Lotkugeln 12 von dem Maschinentisch abgewandt ist. Anschließend wird das Fräswerkzeugs 3 in Rotationsbewegung versetzt und auf eine vorgegebene erste Höhe h1 von der Oberfläche des zweiten Bauteils 1' entfernt bewegt. Die erste Höhe h1 wird berechnet, indem von dem Durchmesser der Lotkugeln die definierte Dicke d der Restlotmenge der Kontaktpads 21 der Leiterplatte abgezogen wird. Vorteilhafterweise wird die Leiterplatte mittels einer Höhenvermessung vermessen. Anschließend wird die erste Höhe h1 für jeden Anschluss mittels des Ergebnisses der Höhenvermessung korrigiert, so dass das Fräswerkzeug 3 für jeden Anschluss die korrigierte erste Höhe h1 verwendet.

Anschließend werden die Lotkugeln 12 abgefräst, so dass deren Lotvolumen reduziert wird (siehe Fig. 5b)). Hierfür sind mindestens zwei verschiedene Varianten denkbar:
Die erste Variante entspricht dem in Fig. 3 gezeigten z-Achsenfräsen, welches auf das Vorbereiten des zweiten Bauteils 1' adaptiert wird. Vor dem Erreichen der ersten Höhe h1 wird das Fräswerkzeug 3 in x-y-Richtung über die Position einer Lotkugel 12 gefahren. Anschließend wird das Fräswerkzeug 3 in z-Richtung auf die Höhe h1 gefahren. Anschließend fährt das Fräswerkzeug 3 zurück auf die Ausgangshöhe. Diese Schritte werden für jede der Lotkugeln 12 wiederholt.
Die zweite Variante entspricht dem in Fig. 4 gezeigten "Milling-Fräsverfahrens", welches auf das Vorbereiten des zweiten Bauteils 1' adaptiert wird. Das Fräswerkzeug 3 behält hierbei die erste Höhe h1 bei und wird über alle Lotkugeln 12 bewegt.

Das so vorbereitete zweite Bauteil 1' kann nun auf die Leiterplatte auf der Position des ersten Bauteils 1 gesetzt werden. Davor werden die abgefrästen Lotkugeln mit einem Flussmittel versehen. Nachdem das zweite Bauteil 1' auf die Position des ersten Bauteils 1 gesetzt worden ist, sodass jeder der Anschlüsse des zweiten Bauteils 1' auf ein korrespondierendes Kontaktpad 21 platziert ist, wird das zweite Bauteil 1' angelötet. Hierfür kann ein herkömmliches Reflow-Lötverfahren in einem Ofen verwendet werden.

### Bezugszeichenliste

- 1: erstes Bauteil
- 1': zweites Bauteil
- 11, 11': Gehäuse
- 12, 12': Lotkugel
- 2: Leiterplatte, bzw. Substrat
- 21: Kontaktpad
- 3: Fräswerkzeug
- d: definierte Dicke der Restlotmenge
- B: Bewegung
- h1: vorgegebene erste Höhe
- h2: vorgegebene zweite Höhe
- x-y: x-y-Ebene
- z: z-Richtung, orthogonal zur Leiterplatte/des Bauteils (x-y-Ebene)

## Patentansprüche

1. Verfahren zum Ersetzen eines auf einer Leiterplatte (2) aufgebrachten ersten Bauteils (1) durch ein baugleiches zweites Bauteil (1'), wobei das erste Bauteil (1) ein Gehäuse (11) und eine Oberfläche mit einer Vielzahl von Anschlüssen aufweist, wobei jeder der Anschlüsse über eine separate Lötverbindung mit jeweils einem Kontaktpad (21) der Leiterplatte (2) verbunden ist, wobei das zweite Bauteil (1') jeweils ein Gehäuse (11') und eine Oberfläche mit einer Vielzahl von Anschlüssen mit jeweils einer Lotkugel (12') mit einem vorgegebenen Durchmesser aufweist, wobei die Fräse einen planaren Maschinentisch und ein Fräswerkzeug (3) aufweist, umfassend:
- Entfernen des ersten Bauteils (1) von der Leiterplatte (2), so dass jeweils eine, insbesondere auf jedem der Kontaktpads (21) identische, Restlotmenge mit einer definierten Dicke (d) auf den Kontaktpads (21) bestehen bleibt;
- Vorbereiten des zweiten Bauteils (1') mittels der Fräsmaschine:
i. Positionieren und Fixieren des zweiten Bauteils (1') auf dem Maschinentisch, wobei das zweite Bauteil (1') derart auf dem Maschinentisch positioniert wird, dass die Oberfläche mit der Vielzahl von Anschlüssen von dem Maschinentisch abgewandt ist;
ii. Versetzen des Fräswerkzeugs (3) in Rotationsbewegung und Bewegen des Fräswerkzeugs (3) auf eine vorgegebene erste Höhe (h1) von der Oberfläche des zweiten Bauteils (1') entfernt, welche vorgegebene erste Höhe (h1) um die definierte Dicke (d) der Restlotmenge der Kontaktpads (21) der Leiterplatte (2) kleiner als der Durchmesser der Lotkugeln (12') ist;
iii. Reduzieren des Lotvolumens von jeder der Lotkugeln (12') mittels des Fräswerkzeugs (3);
- Versehen der reduzieren Lotkugeln (12') des zweiten Bauteils (1') mit einem Flussmittel;
- In Kontakt Bringen des zweiten Bauteils (1') mit der Leiterplatte (2), wobei jeder der Anschlüsse des zweiten Bauteils (1') auf ein korrespondierendes Kontaktpad (21) platziert wird;
- Anlöten des zweiten Bauteils (1') auf die Leiterplatte (2) durch ein Reflow-Lötverfahren.

2. Verfahren nach Anspruch 1, wobei zum Reduzieren des Lotvolumens der Lotkugeln (12') die vorgegebene erste Höhe (h1) des Fräswerkzeugs (3) beibehalten wird und wobei das Fräswerkzeug (3) in einer zur Oberfläche des zweiten Bauteils (1') im Wesentlichen parallelen Ebene über alle Anschlüsse hinweg, insbesondere mäanderförmig, bewegt wird.

3. Verfahren nach Anspruch 1, wobei zum Reduzieren des Lotvolumens der Lotkugeln (12') das Fräswerkzeug (3) über jede Position eines Anschlusses in einer die Lotkugel (12') nicht berührenden Ausgangshöhe gefahren wird, und wobei das Lötwerkzeug für jeden Anschluss bei Erreichen der entsprechenden Position des Anschlusses in einer zur Oberfläche des zweiten Bauteils (1') orthogonalen Richtung auf die vorbestimmte erste Höhe (h1) und anschließend zurück auf die Ausgangshöhe gefahren wird.

4. Verfahren nach zumindest einem der vorherigen Ansprüche, wobei die Leiterplatte (2) zum Entfernen des ersten Bauteils (1) auf den Maschinentisch der Fräse positioniert wird und wobei das erste Bauteil (1) mittels der Fräse entfernt wird.

5. Verfahren nach Anspruch 4, wobei zum Entfernen des ersten Bauteils (1) die folgenden Verfahrensschritte durchgeführt werden:
- Positionieren des Fräswerkzeugs (3) über der Position eines ersten Anschlusses, wobei sich das Fräswerkzeug (3) in einer die Leiterplatte (2) nicht berührenden Ausgangshöhe über der Leiterplatte (2) befindet;
- Versetzen des Fräswerkzeugs (3) in Rotationsbewegung und Bewegen des Fräswerkzeugs (3) durch das erste Bauteil (1) hindurch in einer zu der Oberfläche der Leiterplatte (2) im Wesentlichen orthogonalen Richtung auf eine vorgegebene zweite Höhe (h2) über der Leiterplatte (2);
- Zurückbewegen des Fräswerkzeugs (3) auf die Ausgangshöhe;
- Wiederholen der Verfahrensschritte a) bis c) für die weiteren Anschlüsse.

6. Verfahren nach Anspruch 4 oder 5, wobei das Bauteil (1) mittels eines Hilfsmittels an der Leiterplatte (2) fixiert wird.

7. Verfahren nach Anspruch 4, wobei zum Entfernen des ersten Bauteils (1) das Fräswerkzeug (3) auf eine vorgegebene zweite Höhe (h2) gefahren wird und wobei das Fräswerkzeug (3) unter Beibehalten der zweiten Höhe (h2) in einer zur Oberfläche des ersten Bauteils (1) im Wesentlichen parallelen Ebene über alle Anschlüsse hinweg, insbesondere mäanderförmig, bewegt wird.

8. Verfahren nach zumindest einem der Ansprüche 4 bis 7, wobei die zweite Höhe (h2) derart gewählt wird, dass die definierte Dicke (d) der Restlotmenge in einem Bereich zwischen 10 µm bis 90 µm liegt.

9. Verfahren nach zumindest einem der vorherigen Ansprüche, wobei die Leiterplatte (2) nach Entfernen des ersten Bauteils (1) mittels einer Höhenvermessung, insbesondere eine Laserhöhenvermessung, vermessen wird und eine Abweichung der tatsächlichen Dicke der Restlotmenge von der definierten Dicke (d) der Restlotmenge für jedes der Kontaktpads (21) bestimmt wird.

10. Verfahren nach Anspruch 9, wobei vor dem Reduzieren des Lotvolumens der Lotkugeln (12') die vorgegebene erste Höhe (h1) für jeden Anschluss mittels des Ergebnisses der Höhenvermessung korrigiert wird, so dass das Fräswerkzeug (3) für jeden Anschluss die korrigierte erste Höhe verwendet.

11. Verfahren nach zumindest einem der vorherigen Ansprüche, wobei das Fräswerkzeug (3) zum Entfernen des ersten Bauteils (1) und/oder Reduzieren des Lotvolumens der Lotkugeln (12') des zweiten Bauteils (1') in eine Rotationsbewegung mit einer Geschwindigkeit zwischen 10.000 rpm und 90.000 rpm, bevorzugt zwischen 60.000 rpm und 90.000 rpm, versetzt wird.

12. Verfahren nach zumindest einem der vorherigen Ansprüche, wobei als erstes Bauteil (1) und als zweites Bauteil (1') auf der Ball Grid Array-, Pin Grid Array- oder Land Grid Array-Technologie basierende Bauteile verwendet werden.

13. Fräswerkzeug (3), welches zur Verwendung in einem Verfahren nach zumindest einem der Ansprüche 1 bis 12 ausgestaltet ist.

14. Fräswerkzeug (3) nach Anspruch 13, wobei der Durchmesser des Fräswerkzeugs (3) größer gleich dem Durchmesser der Lotkugeln (12') ist.

15. Fräswerkzeug (3) nach Anspruch 13 oder 14, wobei der Durchmesser des Fräswerkzeugs (3) kleiner als die Summe des Durchmessers der jeweiligen Lotkugeln (12') und dem zweifachen kleinsten Abstand zwischen zwei Lotkugeln (12') ist.
